# FASCICULE DE BREVET EUROPEEN

(11) **EP 0 312 456 B1**
(45) Date de publication et mention de la délivrance du brevet: **20.04.1994**
(21) Numéro de dépôt: 88402589.1
(22) Date de dépôt: 12.10.1988
(51) Int. Cl.: B60R 11/02

(54) **Système anti-vol de récepteur radio utilisé notamment dans un véhicule automobile**
Diebstahlsicherungsvorrichtung für einen Kraftfahrzeugrundfunkempfänger oder dergleichen
Anti-theft device for a motor vehicle radio receiver or the like

(30) Priorité: 12.10.1987 FR 8714030; 09.11.1987 FR 8715472
(43) Date de publication de la demande: 19.04.1989
(73) Titulaire: Rolland, Marie-Christine, F-75015 Paris (FR)
(72) Inventeur: Rolland, Marie-Christine, F-75015 Paris (FR)
(74) Mandataire: Durand, Yves Armand Louis

(56) Documents cités:
- EP-A- 0 116 780
- EP-A- 0 253 947
- CH-A- 446 750
- DE-U- 8 709 924
- DE-U- 8 807 153
- FR-A- 2 461 409
- FR-A- 2 519 832
- FR-A- 2 592 846

## Description

La présente invention concerne un système anti-vol de récepteurs radio utilisés notamment dans un véhicule automobile.

Les récepteurs d'ondes radio montés en particulier sur les véhicules automobiles sont l'objet de convoitise à telles enseignes que nombre de véhicules en stationnement sont fracturés afin de voler, par exemple par attachement, le poste récepteur d'ondes radio.

Pour dissuader les auteurs de tels vols, il a déjà été proposé de monter amoviblement le poste récepteur d'ondes radio au tableau de bord du véhicule.

Cependant, du fait de l'encombrement du poste récepteur, le propriétaire du véhicule, en laissant celui-ci en stationnement pour une durée limitée, cache souvent le poste récepteur d'ondes radio dans son véhicule, par exemple sous un siège avant de celui-ci. Ce comportement est largement connu des auteurs de vols de sorte qu'ils leur suffit de casser une vitre du véhicule et de s'approprier rapidement le récepteur radio camouflé.

EP-A-0 116 780 propose un système permettant de dissuader un voleur de s'approprier un poste récepteur radio monté dans un véhicule automobile.

Le système enseigné par ce document antérieur, répondant au préambule de la revendication 1, comprend un panneau formant partie commande tuner de l'autoradio amoviblement monté au bloc d'amplification, qui est rigidement fixé au tableau de bord du véhicule par l'intermédiaire d'un connecteur électrique comprenant une prise mâle solidaire du panneau frontal amovible et une prise femelle solidaire du châssis du bloc d'amplification.

Cependant, ce système connu a pour inconvénient d'être encombrant du fait que le panneau frontal amovible est de dimensions relativement importantes puisqu'elles correspondent sensiblement aux dimensions du châssis considéré en coupe transversale et comporte la prise de connecteur faisant nettement saillie de la face arrière du panneau frontal afin de permettre la connexion électrique entre le panneau et les différents circuits électroniques dans le châssis du bloc d'amplification.

Autrement dit, l'utilisateur du système enseigné par EP-A-0 116 780 serait tenté de dissimuler la partie amovible à un endroit particulier du véhicule, telle que par exemple la boîte à gants, plutôt que de l'emporter avec lui du fait que la partie amovible n'est pas du tout logeable dans une partie de vêtement, telle qu'une poche, de l'utilisateur.

L'invention propose un système incitant l'utilisateur à emporter sur lui la partie amovible de commande tuner de façon à dissuader au maximum toute personne mal intentionnée de tenter un vol avec effraction de l'autoradio.

A cet effet, le système conforme à l'invention comprend les caractéristiques définies dans la partie caractérisante de la revendication 1.

Le bloc d'amplification précité comprend un logement destiné à recevoir en partie le boîtier de la partie commande tuner et dans lequel sont fixés les autres éléments de connexion ou de contact électrique se trouvant respectivement en face des éléments de connexion de la partie commande tuner ou en contact électrique avec ceux-ci lorsque la partie commande tuner est insérée dans le logement.

Selon un mode de réalisation, la partie commande tuner est insérée longitudinalement dans le logement précité du bloc d'amplification.

Le tableau de bord du véhicule comprend également une ouverture disposée en regard de l'entrée du logement pour l'introduction de la partie commande tuner.

Avantageusement le dispositif d'affichage est du type à cristaux liquides et les organes de commande sont des touches numériques à effleurement.

Le bloc d'amplification comprend également deux logements pour recevoir respectivement une cassette analogique ou numérique et un disque à lecture laser.

Les moyens de liaison électrique précités sont constitués par des moyens d'enfichage comprenant un connecteur au fond du logement comportant un certain nombre de lames métalliques élastiques de contact formant les autres éléments de connexion précités et, situés sur la face supérieure de la partie commande tuner en arrière de celle-ci, un certain nombre de plots de contact coopérant respectivement avec les lames métalliques et formant les éléments de connexion précités.

Il peut être souhaitable de ne pas réaliser le raccordement de la partie commande tuner au bloc d'amplification par l'ensemble lames métalliques-contacts électriques pour des raisons de fiabilité. En effet, l'extraction et l'insertion de la partie commande tuner du et dans le bloc d'amplification pouvant être effectuées souvent dans la journée, une usure rapide des contacts est à craindre. De plus, ces contacts peuvent être détériorés par la présence d'objets métalliques, tels que clés et/ou pièces de monnaie lors du transport de la partie commande tuner dans une poche.

Pour résoudre ce problème et selon un second mode de réalisation, les éléments de connexion précités des moyens de liaison électrique forment une première connexion à couplage capacitif pour la transmission des signaux haute fréquence provenant de l'antenne aux circuits haute fréquence de la partie commande tuner; une seconde connexion à couplage capacitif pour la transmission des signaux basse fréquence de la partie commande tuner à l'amplificateur basse fréquence du bloc d'amplification et une troisième connexion à couplage électromagnétique pour l'alimentation en énergie de la partie commande tuner.

La première connexion précitée pour la transmission des signaux haute fréquence comprend deux condensateurs composés chacun de deux plaques métalliques disposées en regard l'une de l'autre en position encastrée de la partie commande tuner dans le logement, situées respectivement dans le bloc d'amplification et dans la partie commande tuner, de préférence dans la face inférieure de cette dernière et séparées par une plaque de matériau diélectrique, en céramique, solidaire de la plaque de la partie commande tuner.

La seconde connexion précitée pour la transmission des signaux basse fréquence comprend au moins trois condensateurs pour chaque voie stéréophonique et un pour le retour du courant et comprenant chacun deux plaques métalliques disposées en regard l'une de l'autre en position encastrée de la partie commande tuner dans le logement, situées respectivement dans le bloc d'amplification et dans la partie commande tuner, de préférence dans la face inférieure de cette dernière et séparées par une plaque de matériau diélectrique, en céramique, solidaire de la plaque de la partie commande tuner.

Avantageusement le matériau diélectrique précité a une permittivité relative comprise entre 500 et 2000.

La troisième connexion précitée comprend deux bobinages couplés situés respectivement dans le bloc d'amplification en sortie d'un convertisseur courant continu-courant alternatif et dans la partie commande tuner, de préférence dans la face inférieure de cette dernière.

La partie visible de la partie commande tuner repose sur un piédestal, en caoutchouc dur, solidaire de la face frontale de la partie fixe du véhicule.

Le système comprend de plus un dispositif mécanique déclenché lors de l'insertion de la partie commande tuner dans le logement pour presser la partie arrière de la partie commande tuner afin d'assurer parfaitement les connexions précitées.

Le système comprend également un organe de commande de l'éjection de la partie commande tuner hors du logement.

De préférence, un code secret est mémorisé dans la partie commande tuner et est comparé à un autre code secret mémorisé dans le bloc d'amplification et en ce que la mise en service du système est validée en cas de correspondance entre les deux codes secrets, l'opération de comparaison s'effectuant dès que le bloc d'amplification est alimenté.

Cette dernière caractéristique est intéressante car elle dissuade complètement toute personne désireuse de s'approprier par effraction le bloc d'amplification solidaire du tableau de bord du véhicule automobile puisque ce dernier serait totalement inutilisable en l'absence de la partie commande tuner qui doit lui être normalement associée.

L'invention sera mieux comprise, et d'autres buts, caractéristiques, détails et avantages de celle-ci apparaîtront plus clairement au cours de la description explicative qui va suivre faite en référence aux dessins schématiques annexés donnés uniquement à titre d'exemple illustrant deux modes de réalisation de l'invention, et dans lesquels :
La figure 1 est une vue frontale d'un tableau de bord d'un véhicule automobile comportant le système conforme à l'invention.
La figure 2 est une vue en perspective agrandie suivant la flèche II de la figure 1 du système de l'invention.
La figure 3 est une vue en perspective de la partie commande tuner suivant un premier mode de réalisation.
La figure 4 est une vue en perspective avec arrachement partiel représentant l'assemblage de la partie commande tuner à un connecteur du bloc d'amplification selon l'invention ;
La figure 5 représente sous forme de schéma-bloc les différents composants électroniques situés respectivement dans la partie commande tuner et dans le bloc d'amplification du système de l'invention ;
La figure 6 est une vue de dessus notamment de la partie commande tuner suivant un second mode de réalisation ;
La figure 7 est une vue suivant la flèche VII de la figure 6 ;
La figure 8 est une vue en perspective représentant un dispositif mécanique de maintien de la partie commande tuner dans le logement du bloc d'amplification ; et
la figure 9 représente sous forme de schéma-bloc les composants ou circuits électriques présents respectivement dans la partie commande tuner et dans le bloc d'amplification du système de l'invention.

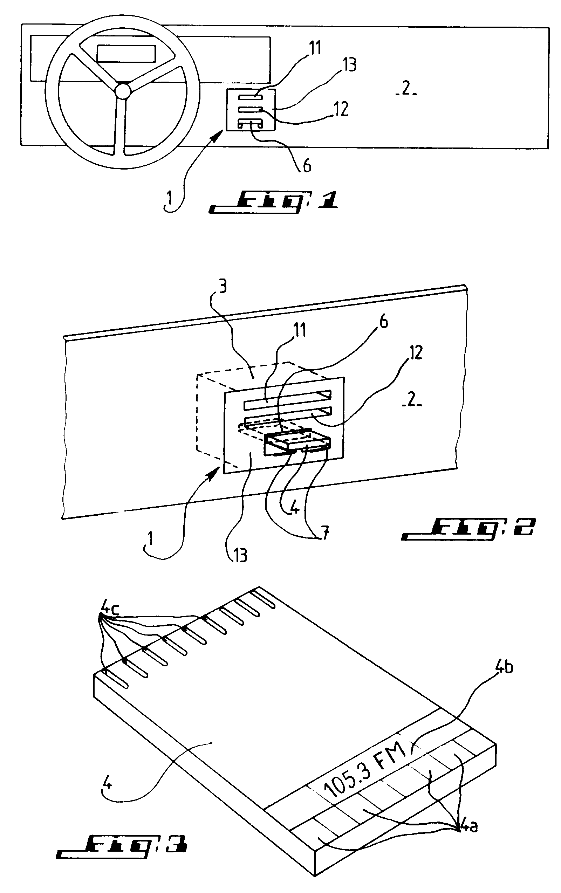

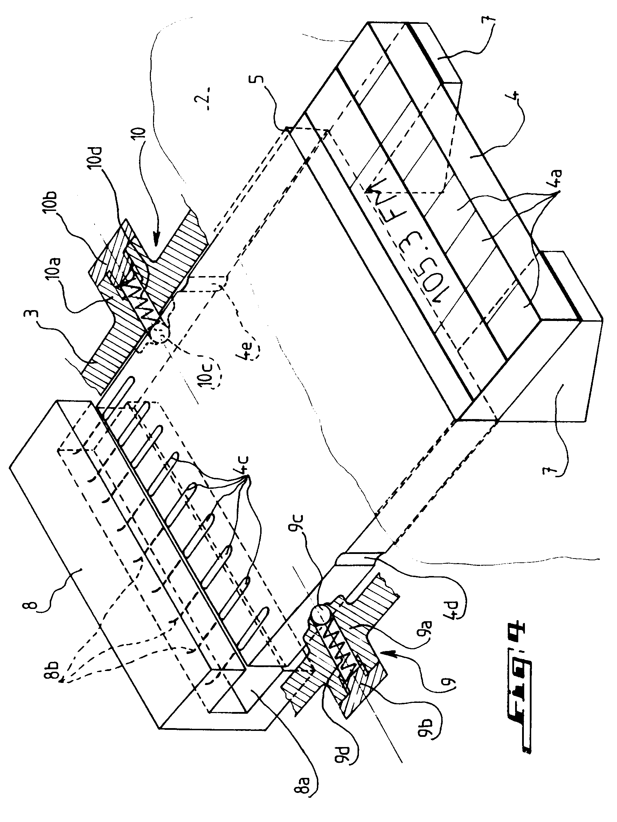

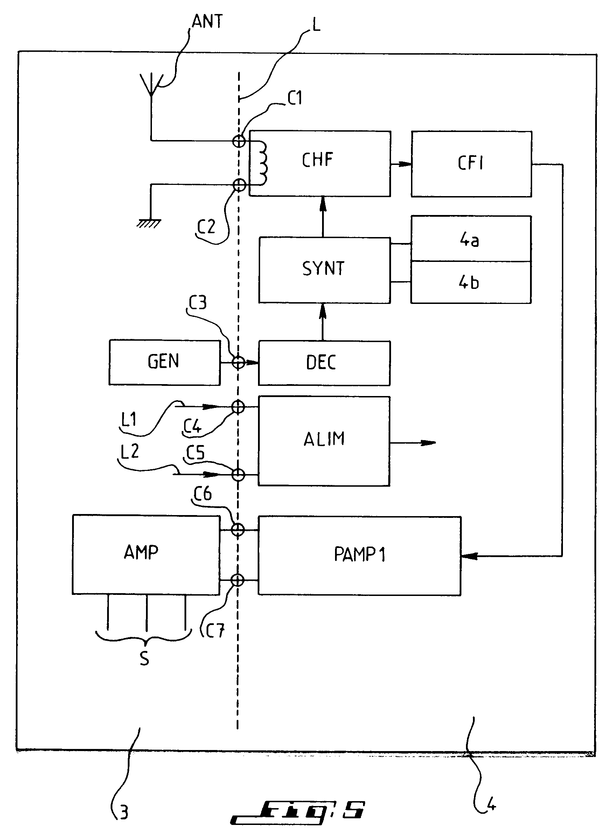

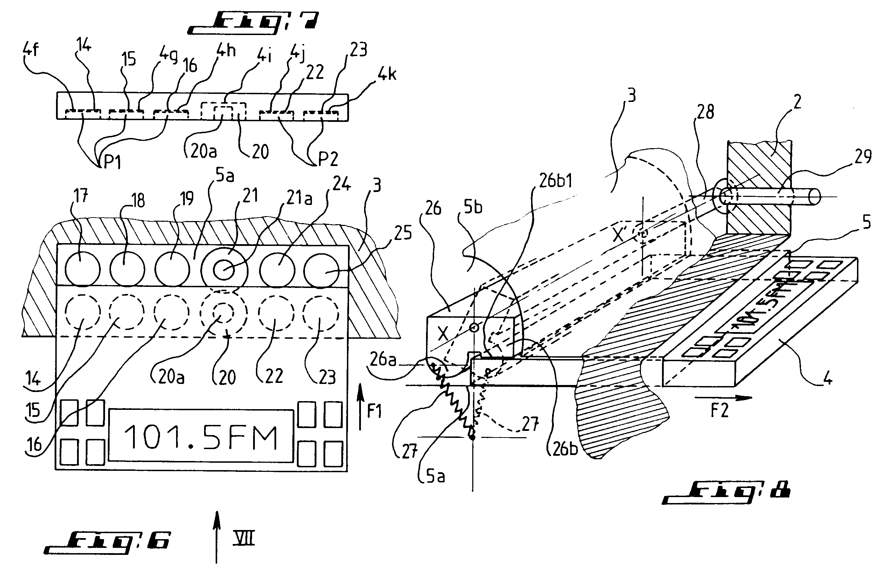

En se reportant aux figures 1 à 5, un poste récepteur d'ondes radiophoniques 1 est monté sur une partie fixe 2 d'un véhicule constituée par exemple par le tableau de bord de celui-ci. Le poste récepteur 1 comprend deux parties séparées, une partie 3 formant châssis ou bloc d'amplification solidaire de façon inviolable, par exemple par des vis de fixation (non représentées), de la face arrière du tableau de bord 2 et une partie 4 de commande de prise et de sélection d'ondes radio AM ou FM ou partie commande tuner à touches 4a de commande numérique par exemple du type à effleurement pour la recherche de fréquences et de sélections des ondes radio et à dispositif d'affichage 4b, notamment à cristaux liquides, de fréquences recherchées et des stations. La partie commande tuner 4 est montée amoviblement dans le bloc d'alimentation 3 et se présente sous la forme d'un boîtier plat parallélépipèdique rectangle de dimensions analogues aux dimensions d'une carte de paiement ou de crédit et susceptible d'être engagé dans un logement central 5 de forme conjuguée du bloc d'amplification 3. Pour permettre l'insertion de la partie 4 dans le logement 5, le tableau de bord 2 comporte une ouverture rectangulaire 6 située en regard du logement 5. La partie commande tuner 4, lorsque disposée longitudinalement dans le logement 5, laisse apparaître extérieurement et donc de façon visible environ un tiers de sa surface de façon que les touches de commande 4a soient accessibles et que le dispositif d'affichage 4b notamment de la fréquence sélectionnées et de la gamme d'onde choisie, AM ou FM, soit également visible, les touches 4a et le dispositif d'affichage 4b étant situés sur la face supérieure de la partie 4. Cette portion de surface de la partie 4 débordant extérieurement est supportée par un piédestal 7 en caoutchouc dur solidaire de la face avant du tableau de bord 2.

La partie 4 comprend également un certain nombre d'organes métalliques formant plots de contacts 4c disposés longitunalement à la partie 4 et parallèlement les uns par rapport aux autres sur la face supérieure de la partie 4 à l'opposé des touches de commande 4a. Les organes de contacts 4c sont reliés électriquement aux différents circuits électroniques disposés dans le boîtier de la partie 4 et qui seront définis ultérieurement. Un connecteur 8, se présentant sous la forme d'un barreau parallélépipèdique, est fixé au fond du logement 5 et comprend une rainure 8a de réception d'une partie d'extrémité du boîtier de la partie 4. Le connecteur 8 comporte plusieurs lames parallèles métalliques élastiques 8b approximativement curvilignes, fixées à la face supérieure de la rainure 8a, et réalisant des connexions électriques par pression respectivement sur les organes de contacts 4c lorsque la partie d'extrémité du boîtier de la partie 4 est encastrée dans la rainure 8a. La partie 4 est maintenue à cette position encastrée par deux organes formant poussoirs rétractables 9 et 10 solidaires du bloc d'amplification 3 et situés en alignement de part et d'autre de la partie 4, symétriquement à l'axe longitudinal de celle-ci. Plus précisément, chaque organe poussoir 9, 10 comprend une partie tubulaire 9a, 10a solidaire du bloc 3 et dont une extrémité est obturée par un bouchon amovible 9b, 10b accessible extérieurement au bloc 3 tandis que l'extrémité opposée comporte une bille 9c, 10c dont une portion fait saillie extérieurement de la partie tubulaire correspondante pour s'encastrer élastiquement dans un logement correspondant 4d, 4e réalisé dans une face latérale du boîtier de la partie 4. Les logements 4d et 4e sont chacun en forme d'encoche allongée à fond courbe perpendiculaire à la face plane supérieure de la partie 4 et sont disposés symétriquement à l'axe longitudinal de la partie 4. Bien entendu, il est possible de réaliser les logements 4d et 4e selon une forme différente, par exemple en forme de calotte sphérique. Chaque bille 9b, 10b est maintenue à l'extrémité correspondante de la partie tubulaire 9, 10 par un organe élastique de rappel, tel qu'un ressort 9d, 10d monté précontraint coaxialement dans la partie tubulaire correspondante.

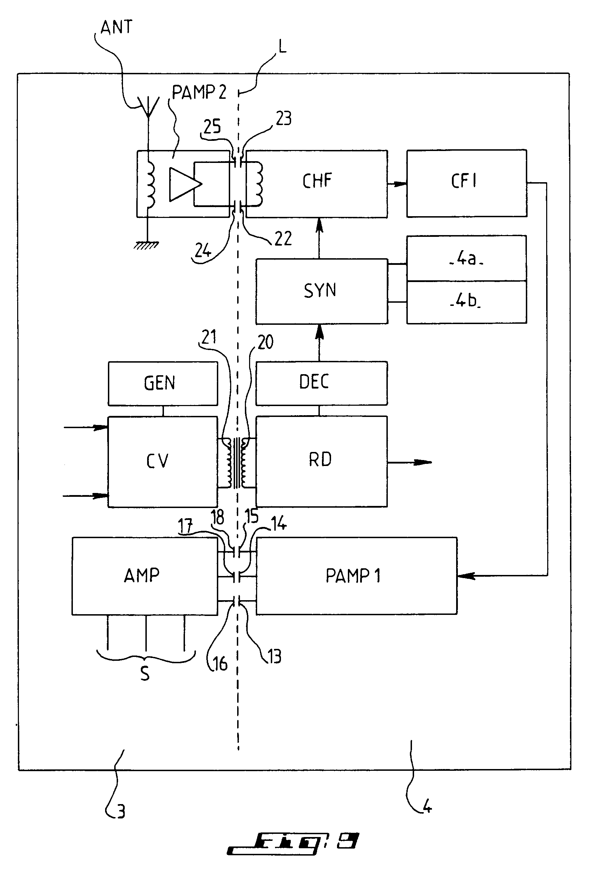

La figure 5 montre les différents circuits électroniques présents respectivement dans la partie fixe formant bloc d'amplification 3 et la partie amovible constituée par la partie commande tuner 4, la séparation entre ces deux parties étant symbolisée par la ligne en pointillé L. Sur cette ligne L sont symbolisées les connexions électriques C1 à C7 établies lorsque les lames élastiques 8b sont en contact respectivement sur les plots de contact 4c une fois la partie commande tuner 4 insérée dans le logement 5. Le bloc d'amplification 3 comprend ainsi un circuit amplificateur basse fréquence AMP dont les sorties S sont reliées aux hauts-parleurs de reproduction du son (non représentés) et dont les entrées sont reliées, par l'intermédiaire des connexions C6 et C7, aux sorties correspondantes d'un circuit pré-amplificateur stéréophonique PAMP1 monté dans la partie commande tuner 4. Il est à noter que la liaison électrique réalisée par la connexion C6 comporte en fait deux fils conducteurs de liaison, chacun pour une voie stéréophonique, tandis que la liaison électrique établie par la connexion C7 comporte au moins un fil conducteur pour le retour du courant. Le bloc d'amplification 3 comprend également le connecteur (non représenté) de raccord à l'antenne de réception des ondes radiophoniques symbolisées en ANT et tel que la sortie d'antenne est reliée à la connexion C1 et la masse à la connexion C2, lesquelles connexions C1 et C2 relient l'antenne à l'entrée du circuit haute fréquence CHF de la partie commande tuner 4. Les liaisons L1 et L2 symbolisent les fils électriques de raccordement à un dispositif d'alimentation électrique, constitué dans le cas présent par la batterie du véhicule, et reliés respectivement aux connexions C4 et C5 également reliées au dispositif d'alimentation ALIM des différents circuits de la partie commande tuner 4. Enfin, le bloc d'amplification 3 comprend un dispositif générateur GEN d'un code secret de préférence établi à l'usine lors du montage du poste récepteur radio sur le véhicule automobile. Ce dispositif générateur peut être du type comportant une mémoire dans laquelle est mémorisé le code secret qui est fourni en sortie du dispositif générateur lorsque par exemple le bloc d'amplification 3 est alimenté. Un tel dispositif générateur n'a pas à être décrit en détail car déjà connu en soi. La sortie du dispositif générateur GEN est reliée, par l'intermédiaire de la connexion C3, à l'entrée d'un circuit de décodage DEC de la partie commande tuner 4 susceptible de décoder le code secret mémorisé dans le dispositif générateur GEN et, lorsque ce dernier a été reconnu, de transmettre un signal de commande autorisant la mise en fonctionnement d'un dispositif synthétiseur SYNT de la partie commande tuner 4. Le dispositif de décodage DEC comprend une mémoire dans laquelle est mémorisé un code secret avant remise de la partie commande tuner 4 à l'utilisateur du poste récepteur radio, ce code étant de préférence identique à celui mémorisé dans le dispositif générateur GEN du bloc d'amplification 3. Le dispositif de décodage DEC comprend de plus un comparateur relié au dispositif générateur GEN par la connexion C3 et à la mémoire du circuit de décodage DEC pour comparer les deux codes secrets et, en cas d'égalité de ceux-ci, délivrer le signal de sortie de commande au circuit synthétiseur SYNT. Le circuit synthétiseur SYNT est relié, d'une part, aux touches de commande 4a et au dispositif d'affichage 4b et, d'autre part, au circuit CHF, dont la sortie est reliée à un circuit de fréquence intermédiaire CFI. Le signal de fréquence intermédiaire en sortie du circuit CFI, après démodulation, est appliqué à l'entrée du circuit pré-amplificateur PAMP1. Les circuits CHF, CFI, SYNT, ALIM et PAMP1 n'ont pas à être décrits plus en détail car étant des circuits classiques.

Les références 11 et 12 désignent deux fentes d'introduction respectivement d'une cassette audio analogique ou numérique et d'un disque audio à lecteur laser lus chacun dans le bloc d'amplification 3, les moyens de reproduction, connus en soi, n'étant pas représentés pour des raisons de simplification. Les fentes 11 et 12 sont situées au-dessus de la fente d'ouverture d'introduction 6 de la partie commande tuner 4.

Les boutons (non représentés) de commande des réglages du volume du son et de balance des hauts-parleurs peuvent être disposés à proximité de l'ouverture 6 d'introduction de la partie commande tuner 4 sur un panneau frontal 13 solidaire de la face avant du tableau de bord 2 et comportant diverses indications relatives notamment aux boutons de commande des réglages du son et de la balance des hauts-parleurs. Bien entendu, le panneau frontal 13 comporte des passages ou ouvertures rectangulaires communiquant respectivement avec les fentes 11, 12 et l'ouverture 6.

Les circuits de la partie commande tuner 4 peuvent être montés dans celle-ci sous forme de circuit imprimé de façon que la partie 4 soit la plus compacte possible.

Ainsi, la partie commande tuner 4 peut être facilement transportée par un utilisateur dans une poche et il lui suffit d'introduire la partie 4 à travers l'ouverture 6 pour l'encastrer dans le logement 5 et le connecteur 8 et réaliser les liaisons électriques définies ci-dessus entre la partie 4 et le bloc d'amplification 3 afin de rendre opérationnel le poste récepteur radio après reconnaissance des codes secrets mémorisés respectivement dans le bloc d'amplification 3 et la partie 4. En quittant momentanément son véhicule, l'utilisateur retirera la partie commande tuner 4 en la dégageant des organes élastiques de maintien 9 et 10 et la remettant dans sa poche. Il sera alors impossible de voler le bloc d'amplification 3 sans détériorer gravement le tableau de bord et l'élément majeur du poste récepteur radio, à savoir la partie commande tuner 4, ne pourra ainsi pas être dérobée puisque l'utilisateur, grâce au format et au poids minimes de cette partie, analogues à ceux d'une carte de crédit, pourra la conserver dans sa poche.

Le système suivant le deuxième mode de réalisation représenté aux figures 6 à 9 ne diffère du premier mode de réalisation décrit ci-dessus que par l'introduction latérale de la partie commande tuner 4, au lieu d'être introduite longitudinalement comme décrit ci-dessus, et par l'accouplement électrique entre la partie 4 et le bloc d'amplification 3.

Selon ce second mode de réalisation, les touches de commande 4a et le dispositif d'affichage 4b sont disposés longitudinalement sur la face supérieure de la partie de commande 4 au voisinage du bord de celle-ci de façon à être visibles une fois la partie 4 insérée latéralement dans son logement correspondant 5, les touches 4a étant situées de part et d'autre du dispositif d'affichage 4b.

La partie commande tuner 4 comporte des moyens coopérant respectivement avec d'autres moyens du bloc 3 pour réaliser l'interconnexion électrique entre la partie et le bloc d'amplification 3 une fois la partie 4 insérée dans son logement correspondant 5. Les moyens de la partie 4 sont disposés côte à côte en alignement au voisinage du bord longitudinal de la partie 4 parallèle à celui où sont disposées les touches 4a et le dispositif d'affichage 4b. Ces moyens sont disposés dans la face inférieure de la partie 4 et comprennent tout d'abord, de la gauche vers la droite par rapport à la figure 6 où la partie 4 est en train d'être insérée suivant la fléche F1, trois plaques métalliques en forme de pastilles circulaires 14-16 logées et fixées, par exemple par collage, chacune au fond d'un lamage correspondant 4f, 4g, 4h de la partie 4 et susceptibles de coopérer respectivement avec trois autres plaques métalliques identiques aux plaques 14-16 en forme de pastilles circulaires 17-19 solidaires, par exemple par collage, de la face plane horizontale inférieure 5a au fond du logement 5 du bloc d'amplification 3 de façon que les couples de plaques 14, 17 ; 15, 18 ; 16, 19 forment chacun un couplage capacitif pour la transmission des signaux basse fréquence entre le pré-amplificateur PAMP1 de la partie 4 et l'amplificateur basse fréquence AMP du bloc d'amplification 3. Une pastille circulaire P1 en un matériau diélectrique, tel que de la céramique, est logée dans chaque lamage 4f-4h et fixée, par exemple par collage, à une plaque métallique correspondante 14, 15, 16, les pastilles P1 étant situées respectivement entre les plaques 14, 17 ; 15, 18 ; 16, 19 pour réaliser des condensateurs à diélectriques. A titre d'exemple, chaque pastille P1, et donc chaque plaque circulaire 14-19 a un diamètre d'approximativement de 10 millimètres et chaque pastille P1 a une épaisseur de quelques dixièmes de millimètre. De plus, chaque pastille P1 a une permittivité relative comprise entre 500 et 2000 et est par exemple en céramique du type PXE ayant subi une opération de dépolarisation. Les moyens de liaison comprennent de plus un bobinage 20 enroulé autour d'un noyau 20a perpendiculaire à la face inférieure de la partie 4, l'ensemble bobinage 20 et noyau 20a étant logé dans un logement en forme de lamage 4i réalisé dans la face inférieure de la partie 4. Le bobinage 20 coopère avec un bobinage identique 21 logé dans un lamage correspondant de la face 5a de façon qu'à la position encastrée de la plaque 4, les bobinages 20 et 21 soient situés en regard l'un au-dessus de l'autre pour assurer un couplage électro-magnétique nécessaire à l'alimentation en énergie électrique de la partie commande tuner 4. Le bobinage 21 est enroulé autour d'un noyau 21a perpendiculaire à la face 5a. Enfin, les moyens de liaison comprennent deux plaques métalliques en forme de pastille circulaire 22, 23 logées chacune au fond d'un logement formant lamage correspondant 4j et 4k réalisé dans la face inférieure de la partie 4 et fixée par collage. Les deux plaques 22 et 23 coopèrent respectivement avec deux autres plaques métalliques circulaires de dimensions identiques 24 et 25 fixées, par exemple par collage, sur la face 5a de façon qu'en position encastrée de la plaque 4 elles soient en regard l'une au-dessus de l'autre pour réaliser un couplage capacitif pour la transmission des signaux haute fréquence entre la sortie de l'antenne ANT et le circuit haute fréquence CHF de la partie 4 et un autre couplage capacitif assurant la liaison aller-retour du courant nécessaire. Il est de plus à noter que les deux condensateurs formés respectivement par les plaques 14, 17 et 15, 16 correspondent chacun à une voie stéréophonique tandis que le condensateur réalisé par les plaques 16, 19 assure le retour nécessaire du courant. Enfin, deux pastilles P2 en un matériau diélectrique, tel que céramique, sont fixées, par exemple par collage, respectivement aux plaques 22 et 23 et forment deux condensateurs à diélectriques en position encastrée de la partie 4.

En se reportant à la figure 9, où la ligne en pointillés L matérialise la séparation entre la partie fixe du bloc d'amplification 3 et la partie amovible constituée par la partie commande tuner 4, les différents types de couplage définis ci-dessus y sont représentés par leurs symboles respectifs situés sur la ligne L. Cette figure montre la présence d'un circuit convertisseur courant continu-courant alternatif CV, constitué par exemple par un circuit hacheur, et transformant le courant continu d'alimentation de la batterie du véhicule en courant alternatif pour transmettre l'énergie électrique d'alimentation à un circuit redresseur RD par l'intermédiaire des bobinages 20 et 21, la sortie du redresseur alimentant les différents circuits de la partie 4 qui sont d'ailleurs identiques à ceux représentés en figure 5 avec pour seule différence que le circuit de décodage DEC du code secret est relié en sortie du circuit redresseur RD de façon à recevoir le code secret du bloc d'amplification 3 transmis au circuit redresseur RD par l'intermédiaire du circuit convertisseur CV auquel est relié le générateur de code GEN, lequel code secret est transmis au circuit de décodage DEC lorsque par exemple le bloc d'alimentation 3 est alimenté. La référence PAMP2 désigne un pré-amplificateur d'antenne ANT et relié au circuit haute fréquence CHF par l'intermédiaire des condensateurs 22, 24 et 23, 25.

Bien entendu, les plaques des différents condensateurs et les bobinages représentés en figure 6 sont reliés électriquement aux différents circuits du bloc d'amplification 3 et de la partie 4 à la manière représentée en figure 9. Il est de plus à noter que les condensateurs ou capacité formés pour la transmission des signaux basse fréquence en position encastrée de la partie 4 dans le bloc d'amplification 3 permettent également d'éliminer les fréquences intermédiaires.

La figure 8 représente un dispositif mécanique permettant de presser la partie arrière de la partie commande tuner 4 afin de la maintenir en position et d'assurer parfaitement les couplages capacitifs et électromagnétique décrits ci-dessus une fois la partie 4 en position d'utilisation dans son logement correspondant 5. Le fond de ce dernier se termine par une cavité 5b dont la paroi supérieure présente une section transversale sensiblement en forme d'arc de cercle et adaptée pour permettre le basculement autour de son axe longitudinal X-X′ d'une partie formant talon 26, faisant partie du dispositif mécanique susmentionné, et provoqué par l'introduction de la partie 4 au fond 5b de son logement 5. La partie formant talon 26 est représentée en pointillés en position inclinée inactive ou d'attente, d'environ 45° par rapport à l'horizontale, et est maintenue à cette position par un ressort de rappel 27 fixé à l'une de ses extrémités à une partie inférieure allongées semi-cylindrique formant butée 26a de la partie formant talon 25 et à son autre extrémité opposée à un point fixe du bloc d'amplification 3. La partie semi-cylindrique 26a est raccordée à une partie allongée parallélépipèdique 26b perpendiculaire à la partie 26a et dont une face plane inférieure 26b1 vient en appui sur la face supérieure de la partie d'extrémité de la partie commande 4 en position active de la partie formant talon 26.

Un dispositif mécanique d'éjection est également prévu pour éjecter la partie commande tuner 4 hors de son logement 5. Ce dispositif comprend un bras de levier 28 ayant l'une de ses extrémités solidaire de la face extrême de la partie formant talon 26 opposée à celle où est fixée l'une des extrémités du ressort de rappel 27 et son autre extrémité opposée reliée de façon articulée à un organe 29 formant bouton-poussoir d'éjection de la carte 4. L'organe 29 est monté coulissant à travers la paroi frontale du tableau de bord 2 et fait saillie extérieurement de celle-ci pour être accessible.

Avant d'introduire la partie commande tuner 4 dans son logement 5, la partie formant talon 26 est en position d'attente représentée en pointillés. En introduisant la partie 4 dans le logement 5, l'extrémité arrière de celle-ci vient en appui contre la partie formant butée 26a de façon à basculer la partie formant talon 26 dans le sens des aiguilles d'une montre dans la cavité 5b autour de son axe X-X′ jusqu'à ce que la face plane 26b1 de la partie 26b vienne en appui sur la plaque 4, maintenant cette dernière correctement en position et assurant parfaitement les couplages capacitifs et électromagnétique. Le point d'attache du ressort à la face extrême de la partie formant butée 26a s'est déplacée sur une trajectoire approximativement circulaire de la position représentée en pointillés à la position représentée en traits pleins. La partie formant talon 26 est bloquée en position active par la partie semi-cylindrique 26a en butée contre la face extrême arrière de la partie 4 et également par le bras de levier 26, le ressort 27 ayant une force de rappel très faible. L'utilisateur désireux de se voir restituer la partie commande tuner 4 enfonce l'organe poussoir 29 vers la gauche par rapport à la figure 8 de façon à faire pivoter le bras de levier 28 dans un sens correspondant au basculement de la partie formant talon 26 vers sa position d'attente en pointillés. Pendant ce basculement de la partie formant talon 26, la partie semi-cylindrique 26a repousse vers la droite suivant la flèche F2 la partie 4 afin de l'éjecter en partie de son logement 5.

Avantageusement, un contact de fin de course (non représenté) est associé à la partie formant talon 26 pour permettre l'alimentation en énergie électrique de l'ensemble bloc d'amplification 3 - partie 4 lorsque cette dernière est en position encastrée comme représenté en figure 8.

Diverses modifications peuvent être apportées aux deux modes de réalisation ci-dessus décrits. Ainsi, du fait que la partie 4 suivant le second mode de réalisation est insérée latéralement dans son logement 5, il est possible d'implanter un nombre maximum de touches supérieures aux huits touches déjà représentées pour assurer d'autres fonctions telles que des fonctions mémoire permettant la mise en mémoire d'une ou plusieurs stations choisies repérées. De plus, le code secret mémorisé sur la partie amovible 4 peut être enregistré magnétiquement à la manière des cartes de crédit et lu par un dispositif de lecture magnétique disposé dans le bloc d'amplification 3. Ce code confidentiel sera ainsi enregistré sur la carte magnétique livrée avec le matériel au moment de l'achat, afin de pouvoir introduire le code initial sur une seconde carte radio en cas de perte. Le dispositif d'éjection décrit dans le second mode de réalisation peut être également utilisé pour éjecter la partie 4 du premier mode de réalisation. Enfin, un boîtier portatif de la dimension d'un paquet classique de cigarettes, comprenant un système d'alimentation en énergie électrique (batterie d'accumulateur ou pile électrique) et des amplificateurs raccordés à un petit casque pliable permettra à l'utilisateur de la carte radio 4 de terminer l'écoute de la station sur laquelle il est branché, à l'extérieur de son véhicule.

## Revendications

1. Système de réception d'ondes radio utilisé notamment dans un véhicule automobile, comprenant essentiellement un bloc d'amplification audio (3) solidaire rigidement du tableau de bord du véhicule et une partie commande de prise et de sélection des ondes radio ou commande tuner (4) en forme de boîtier parallèlépipédique plat assemblée amoviblement au bloc d'amplification (3) par l'intermédiaire de moyens de liaison électrique déconnectables de façon à rendre opérationnelle ou inopérationnelle la partie commande tuner (4), et comprenant des éléments de connexion ou de contact électrique (4c; 14-16, 20, 22, 23) associés à la partie commande tuner (4) et d'autres éléments de connexion ou de contact électrique (8b; 17-19, 21, 24, 25) associés au bloc d'amplification (3) coopérant respectivement avec les éléments de connexion de la partie commande tuner (4) qui présente sur sa partie visible, en position assemblée au bloc d'amplification (3), des organes de commande (4a) de recherche de fréquence d'ondes radio et de sélection des ondes et un dispositif d'affichage (4b) notamment de fréquences recherchées, caractérisé en ce que le boîtier parallélépipédique plat de la partie commande tuner (4) est de dimensions analogues a celles d'une carte de crédit et les éléments de connexion ou de contact électrique (4c; 14-16, 20, 22, 23) de la partie commande tuner (4) sont réalisés directement sur le boîtier de la partie commande tuner (4) de façon à permettre le logement aisé de la partie commande tuner (4) dans une poche d'un utilisateur.

2. Système selon la revendication 1, caractérisé en ce que le bloc d'amplification (3) précité comprend un logement (5) destiné à recevoir en partie le boîtier de la partie commande tuner (4) et dans lequel sont fixés les autres éléments de connexion ou de contact électrique (8b; 17-19, 21, 24, 25) se trouvant respectivement en face des éléments de connexion (4c; 14-16, 20, 22, 23) de la partie commande tuner (4) ou en contact électrique avec ceux-ci lorsque la partie commande tuner (4) est insérée dans le logement (5).

3. Système selon la revendication 1 ou 2, caractérisé en ce que la partie commande tuner (4) précitée est insérée longitudinalement dans le logement (5) précité du bloc d'amplification (3).

4. Système selon les revendications 1 à 3, caractérisé en ce que le tableau de bord précité (2) du véhicule comprend également une ouverture (6) disposée en regard de l'entrée du logement (5) pour l'introduction de la partie commande tuner (4).

5. Système selon l'une des revendications précédentes, caractérisé en ce que le dispositif d'affichage (4b) est du type à cristaux liquides et les organes de commande (4a) sont des touches numériques à effleurement.

6. Système selon l'une des revendications précédentes, caractérisé en ce que le bloc d'amplification (3) comprend également deux logements (11) et (12) pour recevoir respectivement une cassette analogique ou numérique et un disque à lecture laser.

7. Système selon l'une des revendications précédentes, caractérisé en ce que les moyens de liaison électrique précités sont constitués par des moyens d'enfichage comprenant un connecteur (8) au fond du logement (5) comportant un certain nombre de lames métalliques élastiques de contact formant les autres éléments de connexion précités et, situés sur la face supérieure de la partie commande tuner (4) en arrière de celle-ci, un certain nombre de plots de contact (4c) coopérant respectivement avec les lames métalliques (8b) et forment les éléments de connexion précités.

8. Système selon l'une des revendications 1 à 6, caractérisé en ce que les éléments de connexion précités des moyens de liaison électrique forment une première connexion (22, 24; 23, 25) à couplage capacitif pour la transmission des signaux haute fréquence provenant de l'antenne aux circuits haute fréquence (CHF) de la partie commande tuner (4); une seconde connexion (14, 17; 15, 18; 16, 19) à couplage capacitif pour la transmission des signaux basse fréquence de la partie commande tuner (4) à l'amplificateur basse fréquence (AMP) du bloc d'amplification (3) et une troisième connexion (20, 21) à couplage électromagnétique pour l'alimentation en énergie de la partie commande tuner (4).

9. Système selon la revendication 8, caractérisé en ce que la première connexion précitée pour la transmission des signaux haute fréquence comprend deux condensateurs composés chacun de deux plaques métalliques (22, 24; 23, 25) disposées en regard l'une de l'autre en position encastrée de la partie commande tuner (4) dans le logement (5), situées respectivement dans le bloc d'amplification (3) et dans la partie commande tuner (4), de préférence dans la face inférieure de cette dernière et séparées par une plaque de matériau diélectrique (P), en céramique, solidaire de la plaque (21; 22) de la partie commande tuner (4).

10. Système selon la revendication 8, caractérisé en ce que la seconde connexion précitée pour la transmission des signaux basse fréquence comprend au moins trois condensateurs (13, 16; 14, 17; 15, 18), et (13, 14; 14, 17) pour chaque voie stéréophonique et un (15, 18) pour le retour du courant et comprenant chacun deux plaques métalliques disposées en regard l'une de l'autre en position encastrée de la partie commande tuner (4) dans le logement (5), situées respectivement dans le bloc d'amplification (3) et dans la partie commande tuner (4), de préférence dans la face inférieure de cette dernière et séparées par une plaque de matériau diélectrique (P), en céramique, solidaire de la plaque (13; 14; 15) de la partie commande tuner (4).

11. Système selon la revendication 10, caractérisé en ce que le matériau diélectrique précité a une permittivité relative comprise entre 500 et 2000.

12. Système selon la revendication 8, caractérisé en ce que la troisième connexion précitée comprend deux bobinages couplés (20; 19) situés respectivement dans le bloc d'amplification (3) en sortie d'un convertisseur courant continu-courant alternatif (CV) et dans la partie commande tuner (4), de préférence dans la face inférieure de cette dernière.

13. Système selon l'une des revendications 2 à 12, caractérisé en ce que la partie visible de la partie commande tuner (4) repose sur un piédestal (7), en caoutchouc dur, solidaire de la face frontale de la partie fixe (2) du véhicule.

14. Système selon l'une des revendications 8 à 13, caractérisé en ce qu'il comprend un dispositif mécanique (25) déclenché lors de l'insertion de la partie commande tuner (4) dans le logement (5) pour presser la partie arrière de la partie commande tuner (4) afin d'assurer parfaitement les connexions précitées.

15. Système selon l'une des revendications 8 à 14, caractérisé en ce qu'il comprend un organe de commande (27) de l'éjection de la partie commande tuner (4) hors du logement (5).

16. Système selon l'une des revendications précédentes, caractérisé en ce qu'un code secret est mémorisé dans la partie commande tuner (4) et est comparé à un autre code secret mémorisé dans le bloc d'amplification (3) et en ce que la mise en service du système est validée en cas de correspondance entre les deux codes secrets, l'opération de comparaison s'effectuant dès que le bloc d'amplification (3) est alimenté.

## Claims

1. System for receiving radio waves used in particular in an automotive vehicle, essentially comprising an audio-amplification block (3) made rigidly fast to the dashboard of the vehicle and a portion for the control of the intake and of the selection of the radio waves or tuner control (4) in the shape of a flat parallelepipedic box removably assembled to the amplification block (3) through the medium of disconnectable electrical connecting means so as to make the tuner control portion (4) operative or inoperative and comprising electrical connection or contact elements (4c; 14-16, 20, 22, 23) associated with the tuner control portion (4) and other electrical connection or contact elements (8b; 17-19, 21, 24, 25) associated with the amplification block (3) co-operating with the connection elements, respectively, of the tuner control portion (4) which exhibits on its visible part in the position assembled to the amplification block (3), members (4a) for the control of the seeking of frequency of radio waves and of selection of the waves and a device (4b) for displaying in particular the frequencies sought, characterized in that the flat parallelepipedic box of the tuner control portion (4) has a size similar to that of a credit card and the electrical connection or contact elements (4c; 14-16, 20, 22, 23) of the tuner control portion (4) are provided directly on the box of the tuner control portion (4) so as to permit the easy housing of the tuner control portion (4) within one pocket of a user.

2. System according to claim 1, characterized in that the aforesaid amplification block (3) comprises an accommodation housing (5) intended to receive in part the box of the tuner control portion (4) and in which are fastened the other electrical connection or contacts elements (8b; 17-19, 21, 24, 25) located in front of the connection elements (4c; 14-16, 20, 22, 23), respectively, of the tuner control portion (4) or in electrical contact therewith when the tuner control portion (4) is inserted into the housing (5).

3. System according to claim 1 or 2, characterized in that the aforesaid tuner control portion (4) is inserted longitudinally into the aforesaid housing (5) of the amplification block (3).

4. System according to claims 1 to 3, characterized in that the aforesaid dashboard (2) of the vehicle also comprises an opening (6) disposed in front of the inlet of the housing (5) for the insertion of the tuner control portion (4).

5. System according to one of the foregoing claims, characterized in that the display device (4b) is of the type with liquid crystals and the control members (4a) are light-touch digital keys.

6. System according to one of the foregoing claims, characterized in that the amplification block (3) also comprises two accommodations recesses (11) and (12) to receive an analog or digital cassette and a disk for laser reading.

7. System according to one of the foregoing claims, characterized in that the aforesaid electrical connecting means are constituted by plug-in means comprising a connector (8) at the bottom of the housing (5) including a certain number of elastic metallic contact strips forming the aforesaid other connection elements and located on the top face of the tuner control part (4) rearwards thereof, a certain number of contact studs (4c) co-operating with the metallic strips (8b), respectively, and forming the aforesaid connection elements.

8. System according to one of claims 1 to 6, characterized in that the aforesaid connection elements of the electrical connecting means form a first connection (22, 24; 23, 25) with a capacitive coupling for the transmission of high frequency signals from the antenna to the high frequency circuits (CHF) of the tuner control part (4) ; a second connection (14, 17 ; 15, 18 ; 16, 19) with a capacitive coupling for the transmission of low frequency signals from the tuner control part (4) to the low frequency amplifier (AMP) of the amplification block (3) and a third connection (20, 21) with an electromagnetic coupling for the supply of the tuner control part (4) with energy.

9. System according to claim 8, characterized in that the aforesaid first connection for the transmission of high frequency signals comprises two capacitors consisting each one of two metallic plates (22, 24 ; 23, 25) disposed in front of each other in the fitted-in position of the tuner control part (4) in the housing (5), located in the amplification block (3) and in the tuner control part (4), respectively, preferably in the lower face of the latter and separated by a plate of ceramic dielectric material (P) made fast to the plate (21 ; 22) of the tuner control part (4).

10. System according to claim 8, characterized in that the aforesaid second connection for the transmission of low frequency signals comprises at least three capacitors (13, 16 ; 14, 17 ; 15, 18) and (13, 14 ; 14, 17) for each stereophonic channel and one capacitor (15, 18) for the return of the current and comprising each one two metallic plates disposed in front of each other in the position of the tuner control part (4) fitted into the housing (5), located in the amplification block (3) and in the tuner control part (4), respectively, preferably in the lower face of the latter and separated by a plate of dielectric ceramic material (P) made fast to the plate (13 ; 14 ; 15) of the tuner control part (4).

11. System according to claim 10, characterized in that the aforesaid dielectric material has a relative permittivity comprised between 500 and 2,000.

12. System according to claim 8, characterized in that the aforesaid third connection comprises two coupled coils (20 ; 19) located in the amplification block (3) at the output of a d.c.-a.c. converter (CV) and in the tuner control part (4), respectively, preferably in the lower face of the latter.

13. System according to one of claims 2 to 12, characterized in that the visible portion of the tuner control part (4) rests on a pedestal (7) of hard rubber made fast to the front face of the stationary portion (2) of the vehicle.

14. System according to one of claims 8 to 13, characterized in that it comprises a mechanical device (25) started upon the insertion of the tuner control part (4) into the housing (5) to press the back portion of the tuner control part (4) in order to perfectly make the aforesaid connections.

15. System according to one of claims 8 to 14, characterized in that it comprises a member (27) for operating the ejection of the tuner control part (4) out of the housing (5).

16. System according to one of the foregoing claims, characterized in that a secret code is stored into the tuner control part (4) and is compared with another secret code stored into the amplification block (3) and in that the putting into operation of the system is enabled in case of correspondence between both secret codes, the comparison step being effected as soon as the amplification block (3) is fed.

## Patentansprüche

1. Einrichtung zum Empfang von Rundfunkwellen, insbesondere zur Benutzung in einem Kraftfahrzeug, im wesentlichen mit einem Schallwellenverstärkerblock (3), der starr am Armaturenbrett des Fahrzeugs angebracht ist, und mit einem Steuerteil zum Empfang und zur Auswahl der Rundfunkwellen oder einem Steuertuner (4) in Form eines parallelepipedischen flachen Gehäuses, das abnehmbar am Verstärkerblock (3) durch elektrische Verbindungsmittel angebracht ist, die entkoppelbar sind, um den Steuertunerteil (4) funktionsfähig oder funktionsunfähig zu machen, und mit Verbindungs- oder elektrischen Kontaktelementen (4c; 14-16, 20, 22, 23), die dem Steuertunerteil (4) zugeordnet sind, und anderen Verbindungs- oder elektrischen Kontaktelementen (8b; 17-19, 21, 24, 25), die dem Verstärkerblock (3) zugeordnet sind, der jeweils mit den Verbindungselementen des Steuertunerteils (4) zusammenwirken, der auf seinem sichtbaren Teil in seiner am Verstärkerblock (3) angebrachten Stellung Steuerelemente (4a) zur Rundfunkwellenfrequenzsuche und Wellenauswahl besitzt und mit einer Vorrichtung (4b) zur Anzeige insbesondere der gesuchten Frequenzen, dadurch gekennzeichnet, dass das parallelepipedische flache Gehäuse des Steuertunerteils (4) Abmessungen besitzt, die denen einer Kreditkarte entsprechen, und dass die Verbindungs- oder elektrischen Kontaktelemente (4c; 14-16, 20, 22, 23) des Steuertunerteils (4) direkt auf dem Gehäuse des Steuertunerteils (4) so aufgeführt sind, dass sie eine bequeme Aufbewahrung des Steuertunerteils (4) in einer Tasche eines Benutzers erlauben.

2. Einrichtung nach Anspruch 1, dadurch gekennzeichnet, dass der genannte Verstärkerblock (3) einen Aufnahmeraum (5) zur teilweisen Aufnahme des Gehäuses des Steuortunerteils (4) besitzt und in dem die anderen Verbindungs- oder elektrischen Kontaktelemente (8b; 17-19, 21, 24, 25) sich jeweils gegenüber den Verbindungselementen (4c; 14-16, 20, 22, 23) des Steuertunerteils (4) oder in elektrischem Kontakt mit diesen befinden, wenn der Steuertunerteil (4) in den Aufnahmeraum (5) eingebracht worden ist.

3. Einrichtung nach einem der Ansprüche 1 oder 2, dadurch gekennzeichnet, dass der genannte Steuertunerteil (4) in Längsrichtung in den Aufnahmeraum (5) des Verstärkerblocks (3) eingebracht wird.

4. Einrichtung nach den Ansprüchen 1 bis 3, dadurch gekennzeichnet, dass das genannte Armaturenbrett (2) des Fahrzeugs ebenfalls eine Offnung (6) besitzt, die gegenüber dem Eingang des Aufnahmeraums (5) zur Einführung des Steuertunerteils (4) vorgesehen ist.

5. Einrichtung nach einem der vorangehenden Ansprüche, dadurch gekennzeichnet, dass die Anzeigevorrichtung (4b) vom Flüssigkeitskristalltyp ist und die Steuerorgane (4a) numerische, durch leichte Berührung zu betätigende Tasten sind.

6. Einrichtung nach einem der vorangehenden Ansprüche, dadurch gekennzeichnet, dass der Verstärkerblock (3) ebenfalls zwei Aufnahmeräume (11) und (12) zur Aufnahme jeweils einer Analog-oder einer Digitalkassette und einer durch Laserstrahl lesbaren Platte besitzt.

7. Einrichtung nach einem der vorangehenden Ansprüche, dadurch gekennzeichnet, dass die elektrischen Verbindungsmittel von Steckermitteln gebildet werden, die einen Verbinder (8) am Boden des Aufnahmeraumes (5) mit einer gewissen Anzahl von metallischen elastischen Kontaktplättchen, die die genannten anderen Verbindungselemente bilden, und eine gewisse Anzahl von Kontaktklötzen (4c) besitzen, die auf der oberen Fläche des Steuertunelteils (4) in Bezug auf diesen zurückgesetzt angebracht sind und jeweils mit den metallischen Plättchen (8b) zusammenwirken und die genannten Verbindungselemente bilden.

8. Einrichtung nach einem der Ansprüche 1 bis 6, dadurch gekennzeichnet, dass die genannten Verbindungselemente der elektrischen Verbindungsmittel eine erste Verbindung (22, 24; 23, 25) mit kapazitiver Kopplung zur Ubertragung von Hochfrenquenzsignalen von der Antenne zu den Hochfrequenzschaltkreisen (CHF) des Steuertunerteils (4), eine zweite Verbindung (14, 17; 15, 18; 16, 19) mit kapazitiver Kopplung zur Ubertragung von Niederfrequenzsignalen von dem Steuertunerteil (4) zu dem Niederfrequenzverstärker (AMP) des Verstärkerblocks (3) und eine dritte Verbindung (20, 21) mit elektromagnetischer Kopplung zur Speisung des Steuertunelteils (4) mit elektrischer Energie bilden.

9. Einrichtung nach Anspruch 8, dadurch gekennzeichnet, dass die genannte erste Verbindung zur Ubertragung von Hochfrequenzsignalen zwei Kondensatoren besitzt, die jeweils von zwei metallischen Platten (22, 24; 23, 25) gebildet werden, die, wenn der Steuertunerteil (4) in die Aufnahmeöffnung (5) eingesetzt ist, einander gegenüberliegen und im Verstärkerblock (3) bzw. in dem Steuertunerteil (4), vorzugsweise in der unteren Fläche von letzterem und durch eine Platte aus dielektrischem Material (P), aus Keramik, die mit der Platte (21, 22) des Steuertunerteils (4) fest verbunden ist, getrennt sind, angeordnet sind.

10. Einrichtung nach Anspruch 8, dadurch gekennzeichnet, dass die genannte zweite Verbindung zur Ubertragung der Niederfrenquenzsignalen wenigstens drei Kondensatoren (13, 16; 14, 17; 15, 18) und (13, 14; 14, 17) für jeden stereophonischen Pfad und einen (15, 18) zur Stromrückführung besitzt, von denen jeder zwei metallische Platten besitzt, die einander gegenüberliegen, wenn der Steuertunerteil (4) in der Aufnahmeraum (5) eingesetzt ist und in dem Verstärkerblock (3) bzw. in dem Steuertunerteil (4), vorzugsweise in der unteren Flächen von letzterem angeordnet sind und von einer Platte aus dielektrischem Material (P), aus Keramik, die mit der Platte (13; 14; 15) des Steuertunerteils (4) fest verbunden ist, getrennt sind.

11. Einrichtung nach Anspruch 10, dadurch gekennzeichnet, dass das genannte dielektrische Material eine relative Permissivität zwischen 500 und 2000 besitzt.

12. Einrichtung nach Anspruch 8, dadurch gekennzeichnet, dass die genannte dritte Verbindung zwei gekoppelte Spulen (20; 19) besitzt, die in dem Verstärkerblock (3) am Ausgang eines Gleichstrom-Wechselstrom Umformers (CV) bzw. in dem Steuertunerteil (4), vorzugsweise in der unteren Fläche von letzterem, angeordnet sind.

13. Einrichtung nach einem der Ansprüche 2 bis 12, dadurch gekennzeichnet, dass der sichtbare Teil des Steuertunerteils (4) auf einem Sockel (7) aus Hartgummi ruht, der fest mit der Stirnfläche des festen Teils (2) des Fahrzeugs verbunden ist.

14. Einrichtung nach einem der Ansprüche 8 bis 13, dadurch gekennzeichnet, dass sie eine mechanische Vorrichtung (25) besitzt, die bei dem Einsetzen des Steuertunerteils (4) in den Aufnahmeraum (5) ausgelöst wird, um auf den hinteren Bereich des Steuertunerteils (4) zu drücken, damit die genannten Verbindungen perfekt gewährleistet sind.

15. Einrichtung nach einem der Ansprüche 8 bis 14, dadurch gekennzeichnet, dass sie ein Steuerorgan (27) zum Auswurf des Steuertunerteils (4) aus dem Aufnahmeraum (5) besitzt.

16. Einrichtung nach einem der vorangehenden Ansprüche 8 bis 14, dadurch gekennzeichnet, dass ein Geheimkode in dem Steuertunerteil (4) gespeichert ist und mit einem Geheimkode verglichen wird, der in dem Verstärkerblock (3) gespeichert ist, und dass die Inbetriebnahme der Einrichtung bei Ubereinstimmung der zwei Geheimkode gültig gemacht wird, wobei der Vergleich ausgeführt wird, wenn der Verstärkerblock (3) mit Energie gespeist wird.
